# EUROPEAN PATENT APPLICATION

(11) **EP 4 836 666 A1**
(43) Date of publication of application: **04.11.2026**
(21) Application number: 26170403.5
(22) Date of filing: 02.04.2026
(51) Int. Cl.: H10P 72/00, H10P 72/70, H10P 72/76, H10P 72/30

(54) **SUBSTRATE PROCESSING APPARATUS**

(30) Priority: 07.04.2025 JP 2025063213
(71) Applicant: SCREEN Holdings Co., Ltd., Kyoto-shi, Kyoto 602-8585 (JP)
(72) Inventor: ISHII, Hiroaki, Kyoto, 602-8585 (JP); YASUTAKE, Yosuke, Kyoto, 602-8585 (JP); ISHIKAWA, Michiaki, Kyoto, 602-8585 (JP); OKUMURA, Shinichiro, Kyoto, 602-8585 (JP); ISHII, Junichi, Kyoto, 602-8585 (JP); FUNAHASHI, Kazuma, Kyoto, 602-8585 (JP); ABE, Toshihiro, Kyoto, 602-8585 (JP)
(74) Representative: Kilian Kilian & Partner mbB

(57) **Abstract**

A substrate processing apparatus includes: a substrate accommodating section; a cleaning jig accommodating section; a transfer mechanism; a substrate placement section provided with a lift pin that is raised and lowered by motor driving; a processing unit; and a control section. The control section controls a lowering speed of the lift pin to be decreased stepwise in a process in which the lift pin is lowered from a first height position to a second height position.

## Description

### Technical Field

The present disclosure relates to a substrate processing apparatus. Examples of a substrate that is to be processed include semiconductor wafers, substrates for flat panel displays (FPDs) such as liquid crystal display devices and organic electroluminescence (EL) display devices, optical disc substrates, magnetic disc substrates, magneto-optical disc substrates, photomask substrates, ceramic substrates, and solar cell substrates.

### Background Art

A manufacturing process of a semiconductor device involves use of a substrate processing apparatus that processes a substrate such as a semiconductor wafer. For example, as disclosed in Patent Literature 1, such a substrate processing apparatus uses an indexer robot and a main transfer robot to transfer substrates accommodated in a carrier to a plurality of processing units, and carries out surface processing with respect to the substrates.

A transfer mode of a substrate that is to be processed is generally a mode disclosed in Patent Literature 1, specifically, a mode in which a disc-shaped substrate is transferred as it is to a processing unit. Alternatively, the transfer mode may be a mode disclosed in Patent Literature 2, for example. Specifically, the transfer mode may be a mode in which a substrate placed on a protective film attached to an inner side of an annular mount frame (hereinafter, a substrate in such a state will be referred to as a "framed substrate") is transferred to a processing unit.

### Citation List

### Patent Literatures

Patent Literature 1
   Japanese Patent Application Publication Tokukai No. 2022-39827
Patent Literature 2
   Japanese Patent Application Publication Tokukai No. 2010-137349

### Summary of Invention

### Technical Problem

As described above, the modes of transferring substrates to the processing unit are roughly classified into two. However, if processing units and/or transfer robots are provided respectively for these two transfer modes, this may increase a space in which the apparatus is disposed and also increase a manufacturing cost and a running cost of the substrate processing apparatus.

The present disclosure has an objective to provide an apparatus supporting both the general-substrate transfer mode and the framed-substrate transfer mode and to reduce a size and a cost of the apparatus. In particular, the present disclosure has an objective to reduce or prevent positional deviation that may occur when a cleaning jig, which is required when cleaning of a general substrate is carried out by equipment similar to that for a framed substrate, is stacked on a substrate.

### Solution to Problem

In order to attain the above objective, a substrate processing apparatus according to an aspect of the present disclosure is a substrate processing apparatus including: a substrate accommodating section; a cleaning jig accommodating section; a transfer mechanism; a substrate placement section provided with a lift pin that is raised and lowered by motor driving; a processing unit; and a control section. The transfer mechanism transfers a cleaning jig accommodated in the cleaning jig accommodating section to a position above the lift pin located at a lowest standby position, and transfers a substrate accommodated in the substrate accommodating section to a position above the lift pin and above the cleaning jig. The lift pin is raised and lowered at least in a range including (a) a first height position where the substrate having been transferred from the substrate accommodating section by the transfer mechanism is received and (b) a second height position where the substrate is stacked on the cleaning jig. The control section controls a lowering speed of the lift pin to be decreased stepwise in a process in which the lift pin is lowered from the first height position to the second height position. The substrate stacked on the cleaning jig at the second height position is transferred, by the transfer mechanism, as a pre-processing substrate to the processing unit that carries out cleaning processing.

### Advantageous Effects of Invention

According to an aspect of the present disclosure, it is possible to clean a general substrate by using equipment similar to that for a framed substrate, thereby making it possible to reduce a size and a cost of the apparatus. In particular, according to an aspect of the present disclosure, it is possible to reduce or prevent positional deviation that may occur when a cleaning jig, which is required when cleaning of a general substrate is carried out by equipment similar to that for a framed substrate, is stacked on a substrate.

### Brief Description of Drawings

Fig. 1 is a plan view schematically illustrating a configuration of a substrate processing apparatus according to an embodiment of the present disclosure.
Fig. 2 is a perspective view illustrating an example of a configuration of a framed substrate according to the embodiment.
Fig. 3 is a side view schematically illustrating a configuration of a processing unit of the substrate processing apparatus according to the embodiment.
Fig. 4 is a side view schematically illustrating a positional relation between a delivery unit and a cleaning jig accommodating section according to the embodiment.
Fig. 5 is a side view illustrating a configuration of a delivery unit including lift pins and a cleaning jig according to the embodiment.
Fig. 6 is a perspective view illustrating an example of a configuration of a framed substrate accommodating section according to the embodiment.
Fig. 7 is a side view illustrating an example of a configuration of the framed substrate accommodating section according to the embodiment.
Fig. 8 is a block diagram illustrating an example of a configuration of a control section according to the embodiment.
Fig. 9 is a flowchart illustrating a flow of processing with respect to a framed substrate carried out by the substrate processing apparatus according to the embodiment.
Fig. 10 is a diagram illustrating a state observed while cleaning processing is being carried out with respect to a framed substrate by the substrate processing apparatus according to the embodiment.
Fig. 11 is a flowchart illustrating a flow of processing carried out up to cleaning of a general substrate, the processing being carried out by the substrate processing apparatus according to the embodiment.
Fig. 12 is a diagram illustrating a state observed while cleaning processing is being carried out with respect to a substrate with a cleaning jig by the substrate processing apparatus according to the embodiment.
Fig. 13 is a flowchart illustrating a flow of processing with respect to a general substrate after cleaning processing by the substrate processing apparatus according to the embodiment.

### Description of Embodiments

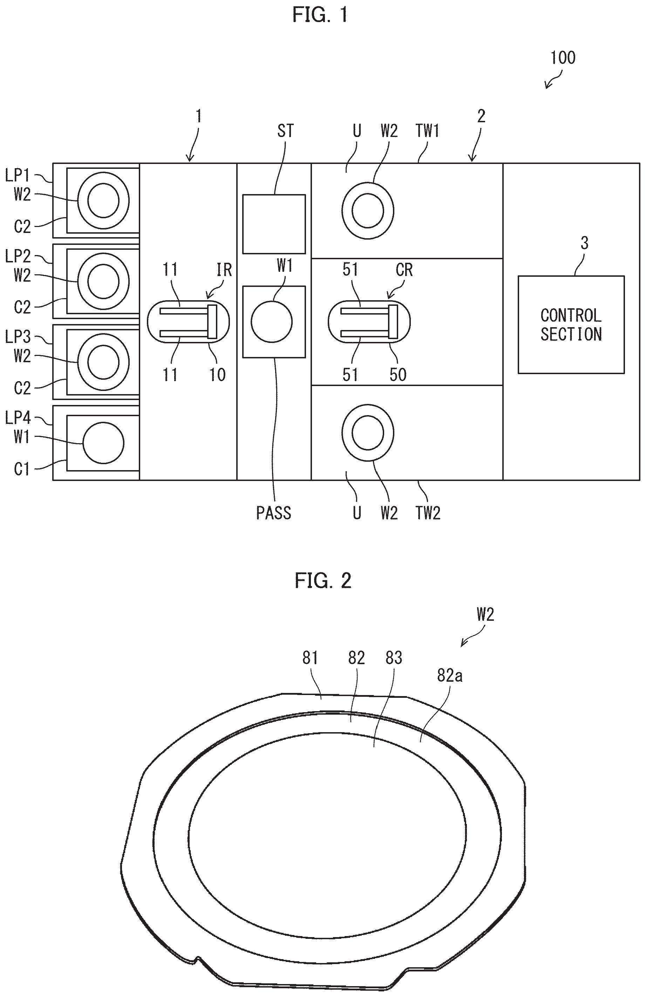

The following will describe an embodiment of the present disclosure with reference to Figs. 1 to 13.

### Configuration of Substrate Processing Apparatus

First, the following will schematically describe, with reference to Figs. 1 to 8, a configuration of a substrate processing apparatus 100. Fig. 1 is a plan view schematically illustrating the configuration of the substrate processing apparatus 100. As illustrated in Fig. 1, the substrate processing apparatus 100 includes an indexer section 1, a processing section 2, and a control section 3.

The substrate processing apparatus 100 is capable of executing various kinds of processing with respect to both a general substrate W1 and a framed substrate W2. The substrate processing apparatus 100 is a single-wafer type apparatus that processes disc-shaped substrates W1 or framed substrates W2 (e.g., semiconductor wafers) one by one.

The description here will deal with a configuration of the framed substrate W2 with reference to Fig. 2. Fig. 2 is a perspective view illustrating an example of the configuration of the framed substrate W2. As illustrated in Fig. 2, the framed substrate W2 includes a frame 81, a film 82, and a substrate 83.

The frame 81 is made of a magnetic material such as stainless steel. The frame 81 is an annular plate-like member. In the example shown in Fig. 2, the frame 81 has an inner peripheral surface having a circular shape in a plan view. The frame 81 has an inner diameter of, for example, approximately 200 mm to 400 mm. The frame 81 has a thickness of, for example, approximately 1 mm to 5 mm.

The film 82 is attached to an inner side of the annular frame 81. The film 82 closes an inner opening of the frame 81. The film 82 is made of a material such as a synthetic resin having elasticity. The substrate 83 is attached to a surface 82a on one side of the film 82. The substrate 83 is, for example, bonded to the surface 82a of the film 82. Examples of the substrate 83 bonded to the film 82 include chip-shaped ones.

### Configuration of Indexer Section

As illustrated in Fig. 1, the indexer section 1 includes an indexer robot IR, a first load port LP1, a second load port LP2, a third load port LP3, and a fourth load port LP4. The indexer robot IR is one example of a first transfer mechanism. The fourth load port LP4 is one example of a substrate accommodating section.

The indexer robot IR has a function of transferring both the substrate W1 and the framed substrate W2. The indexer robot IR includes a base section 10 and a pair of hand sections 11.

The base section 10 is fixed to a frame (not illustrated) of the substrate processing apparatus 100. The pair of hand sections 11 are members that horizontally hold the substrate W1 or the framed substrate W2. The pair of hand sections 11 have a shape capable of holding both the substrate W1 and the framed substrate W2.

The pair of hand sections 11 are rotatably disposed around a vertical axis with respect to the base section 10. Further, the pair of hand sections 11 are configured to be raised and lowered in an up-down direction with respect to the base section 10 by a lifting/lowering mechanism (not illustrated). Operation of each section of the indexer robot IR is controlled by the control section 3.

The indexer robot IR transfers unprocessed framed substrates W2 from the first load port LP1, the second load port LP2, and the third load port LP3 to a delivery unit PASS, and receives the processed framed substrates W2 from the delivery unit PASS.

Further, the indexer robot IR transfers an unprocessed substrate W1 from the fourth load port LP4 to the delivery unit PASS; meanwhile, the indexer robot IR receives a processed substrate W1 from the delivery unit PASS. In this manner, the indexer robot IR exchanges a substrate W1 or a framed substrate W2 with the center robot CR via the delivery unit PASS.

The indexer robot IR may have, in place of the pair of hand sections 11, a first hand section that holds a general substrate W1 and a second hand section that holds a framed substrate W2, for example. In this case, the indexer robot IR may switch between the first hand section and the second hand section according to the type of substrate that is to be transferred.

The first load port LP1, the second load port LP2, and the third load port LP3 are respectively carrier ports that hold carriers C2 each of which accommodates a plurality of framed substrates W2. Further, the fourth load port LP4 is a carrier port that holds a carrier C1 which accommodates a plurality of substrates W1.

Each of the carriers C2 is, for example, a Front Opening Unified Pod (FOUP) that accommodates framed substrates W2 in a sealed state. Meanwhile, the carrier C1 is, for example, a FOUP that accommodates substrates W1 in a sealed state. Note that the carriers C2 and the carrier C1 are not limited to FOUPs, and may alternatively be Standard Mechanical Interface (SMIF) pods, Open Cassettes (OCs), or the like.

### Configuration of Processing Section

The processing section 2 includes the delivery unit PASS, the center robot CR, processing units U, a tower TW1, a tower TW2, and the like. The center robot CR is one example of a second transfer mechanism.

### Delivery Unit

The delivery unit PASS is disposed between the indexer robot IR and the center robot CR, and is configured to hold a substrate W1 or a framed substrate W2. The delivery unit PASS is one example of a substrate placement section.

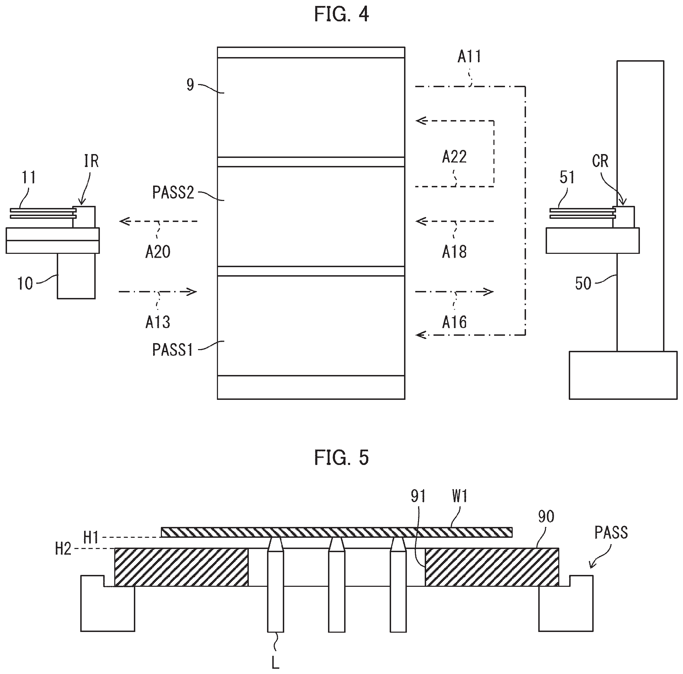

The delivery unit PASS includes a first delivery unit PASS1 and a second delivery unit PASS2. The second delivery unit PASS2 is disposed above the first delivery unit PASS1 (see Fig. 4).

In the first delivery unit PASS1, stacking of a cleaning jig 90 and a substrate W1 is carried out. Meanwhile, in the second delivery unit PASS2, separation of the cleaning jig 90 and the substrate W1 is carried out. Note that an internal structure of the first delivery unit PASS1 and an internal structure of the second delivery unit PASS2 are identical to each other.

### Center Robot

The center robot CR includes a base section 50 and a pair of hand sections 51. The base section 50 is fixed to a frame (not illustrated) of the substrate processing apparatus 100. The pair of hand sections 51 are members that horizontally hold a substrate W1 or a framed substrate W2. The pair of hand sections 51 have a shape capable of holding both the substrate W1 stacked on the cleaning jig 90 and the framed substrate W2.

The pair of hand sections 51 are rotatably disposed around a vertical axis with respect to the base section 50. Further, the pair of hand sections 51 are configured to be raised and lowered in the up-down direction with respect to the base section 50 by a lifting/lowering mechanism (not illustrated). Operation of each section of the center robot CR is controlled by the control section 3.

The center robot CR receives an unprocessed single substrate W1 or a single unprocessed framed substrate W2 from the delivery unit PASS, and transfers the substrate W1 or the framed substrate W2 to the processing unit U. Further, the center robot CR receives a processed substrate W1 or a processed framed substrate W2 having been processed in the processing unit U, and passes the substrate W1 or the framed substrate W2 to the delivery unit PASS.

Two processing units U are provided in such a manner that the center robot CR is interposed therebetween. Each processing unit U carries out various kinds of processing, examples of which include processing using a processing agent (e.g., a processing liquid or a processing gas), processing using electromagnetic waves (e.g., ultraviolet rays), cleaning with a brush, and cleaning with a spray nozzle. Each processing unit U is controlled by the control section 3.

### Towers

The tower TW1 and the tower TW2 are disposed in such a manner that the center robot CR is interposed between the tower TW1 and the tower TW2. In the tower TW1, a plurality of chambers in each of which the processing unit U is disposed are stacked in the up-down direction. In the tower TW2, a plurality of chambers in each of which the processing unit U is disposed are stacked in the up-down direction. The number of towers is not limited to two, and may alternatively be four, for example.

### Configuration of Processing Unit

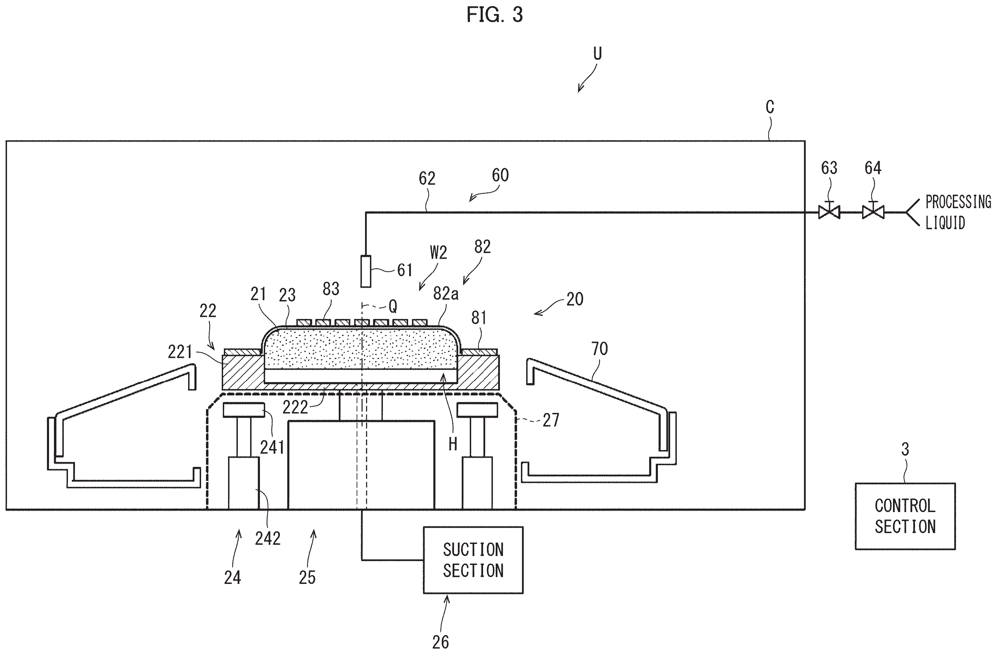

Next, the processing unit U will be described in detail with reference to Fig. 3. Fig. 3 is a side view schematically illustrating a configuration of the processing unit U of the substrate processing apparatus 100.

As illustrated in Fig. 3, the processing unit U is provided with a box-shaped chamber C. The chamber C has, in its inside, a space in which a framed substrate W2 can be placed. The processing unit U carries out various kinds of processing with respect to the framed substrate W2 in the space inside the chamber C. The chamber C has an openable and closable loading/unloading port (not illustrated) for loading an unprocessed framed substrate W2 and unloading a processed framed substrate W2.

Further, the chamber C is provided with a substrate retaining section 20 disposed therein, as illustrated in Fig. 3. The substrate retaining section 20 includes a porous member 21, a base 22, a holding drive section 24, and a rotation drive section 25.

The substrate retaining section 20 rotates a framed substrate W2 around a rotation axis Q while holding the framed substrate W2. The substrate retaining section 20 holds the framed substrate W2 with the substrate 83 being positioned above the film 82. The rotation axis Q is an axis line extending in a vertical direction so as to pass through a center of a circle along which, for example, the inner peripheral surface of the frame 81 lies.

The porous member 21 is a member that adsorbs the film 82 of the framed substrate W2. The porous member 21 has porosity and is made of, for example, ceramic such as alumina.

The base 22 includes a support member 221 and a bottom plate 222. The support member 221 is a member that supports the frame 81 of the framed substrate W2. The support member 221 has, for example, an annular shape in a plan view, and is arranged so as to surround the porous member 21. The frame 81 is placed on an upper surface of the support member 221. The porous member 21 is detachably fixed to the support member 221.

A negative pressure is applied to the porous member 21 and a gap H by a suction section 26. The porous member 21 has porosity. Therefore, when a negative pressure is generated in the gap H, a gas from an adsorption surface 23 of the porous member 21 flows through an inside of the porous member 21 and enters the gap H. Consequently, the film 82 is adsorbed and held by the adsorption surface 23 of the porous member 21.

The holding drive section 24 includes a magnet 241 and a magnet movement drive section 242. By causing a magnetic force from the magnet 241 to act on the magnetic frame 81, the holding drive section 24 presses the frame 81 to the support member 221 so that the frame 81 is held by the support member 221. Note that the magnetic force of the magnet 241 does not act on the support member 221, since the support member 221 is made of a non-magnetic material such as aluminum, for example.

Under control of the control section 3, the holding drive section 24 adjusts a magnetic attraction force acting between the frame 81 and the magnet 241. Specifically, the holding drive section 24 switches between (a) a holding state in which the frame 81 is pressed to and held by the support member 221 by the magnetic attraction force and (b) a holding release state in which the magnetic attraction force on the frame 81 is reduced or eliminated so that the pressing and holding of the frame 81 is released.

The magnet movement drive section 242 moves the magnet 241 between a holding position and a holding release position. The holding position is a position where the magnetic attraction force from the magnet 241 sufficiently acts on the frame 81. The holding release position is a position where the magnetic attraction force from the magnet 241 does not substantially act on the frame 81.

The rotation drive section 25 includes an electric motor as a drive source. The control section 3 controls the electric motor of the rotation drive section 25 so that the porous member 21 and the base 22 rotate integrally around the rotation axis Q. As a result of rotation of the porous member 21 and the base 22 around the rotation axis Q, the framed substrate W2 also rotates around the rotation axis Q. Note that the holding drive section 24 and the rotation drive section 25 are protected from the processing liquid by a drive accommodating member 27.

Although not illustrated, the suction section 26 includes a suction pipe, a suction valve, a suction drive section, and the like. The suction drive section is controlled by the control section 3. An upstream end of the suction pipe of the suction section 26 is connected to the gap H. A downstream end of the suction pipe is connected to the suction drive section.

The suction drive section is, for example, a pump, and sucks a gas in the gap H through the suction pipe. The suction valve is inserted in the suction pipe and switches opening and closing of the suction pipe. The suction valve and the suction drive section are controlled by the control section 3. The control section 3 operates the suction drive section after opening the suction valve. Consequently, a negative pressure is generated in the gap H, so that the film 82 is adsorbed to and held by the porous member 21.

The processing unit U is provided with a discharge section 60. The discharge section 60 includes a nozzle 61, a supply pipe 62, a supply valve 63, and a flow rate adjustment valve 64. The nozzle 61 is disposed above the framed substrate W2 held by the substrate retaining section 20 in the chamber C. The nozzle 61 discharges the processing liquid toward an upper surface of the framed substrate W2.

The nozzle 61 is connected to a downstream end of the supply pipe 62. An upstream end of the supply pipe 62 is connected to a processing liquid supply source. The processing liquid supply source includes a tank in which the processing liquid is stored, and supplies the processing liquid to the upstream end of the supply pipe 62. The supply pipe 62 is provided with the supply valve 63 and the flow rate adjustment valve 64. The supply valve 63 switches opening and closing of the supply pipe 62, and the flow rate adjustment valve 64 adjusts a flow rate of the processing liquid flowing through the supply pipe 62. The supply valve 63 and the flow rate adjustment valve 64 are controlled by the control section 3.

When the nozzle 61 discharges the processing liquid toward the rotating framed substrate W2 in a state where the nozzle 61 is positioned at the processing position, the processing liquid lands on the framed substrate W2. Receiving a centrifugal force generated in connection with rotation of the framed substrate W2, the processing liquid flows radially outward, so as to be scattered outwardly from a peripheral edge of the framed substrate W2. During this process, the processing liquid acts on the framed substrate W2, so that processing according to the type of the processing liquid is carried out with respect to the framed substrate W2. For example, in a case where the processing liquid is a chemical liquid used for cleaning, the substrate 83 is cleaned.

The processing unit U is provided with a guard section 70. The guard section 70 is configured to catch various kinds of processing liquids scattering from the peripheral edge of the framed substrate W2.

### Cleaning Jig Accommodating Section

The delivery unit PASS is provided with a cleaning jig accommodating section 9 that accommodates the cleaning jig 90. Fig. 4 is a side view schematically illustrating a positional relation between the first delivery unit PASS1, the second delivery unit PASS2, and the cleaning jig accommodating section 9.

As illustrated in Fig. 4, the cleaning jig accommodating section 9 is located between the indexer robot IR and the center robot CR, and is disposed above the first delivery unit PASS1 and the second delivery unit PASS2.

This prevents the processing liquid and/or the like from entering the cleaning jig accommodating section 9 from the post-processing substrate W1 or framed substrate W2 transferred to the second delivery unit PASS2.

Fig. 5 is a side view illustrating a configuration of the cleaning jig 90. As illustrated in Fig. 5, the cleaning jig 90 has an opening 91. A plurality of lift pins L provided in the delivery unit PASS are raised and lowered through the opening 91 by motor driving.

The plurality of lift pins L receive, at a second height position H2, a substrate W1 having been transferred thereto from the fourth load port LP4 by the indexer robot IR in a state in which the substrate W1 is kept horizontally. When the plurality of lift pins L are lowered to the second height position H2, the substrate W1 is stacked on the cleaning jig 90.

### Framed Substrate Accommodating Section

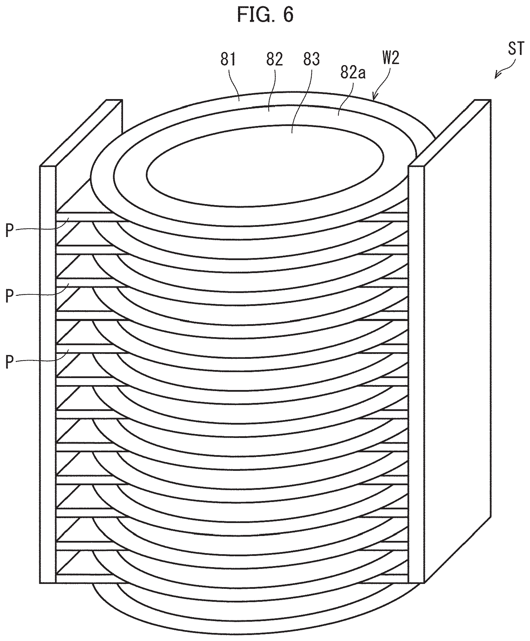

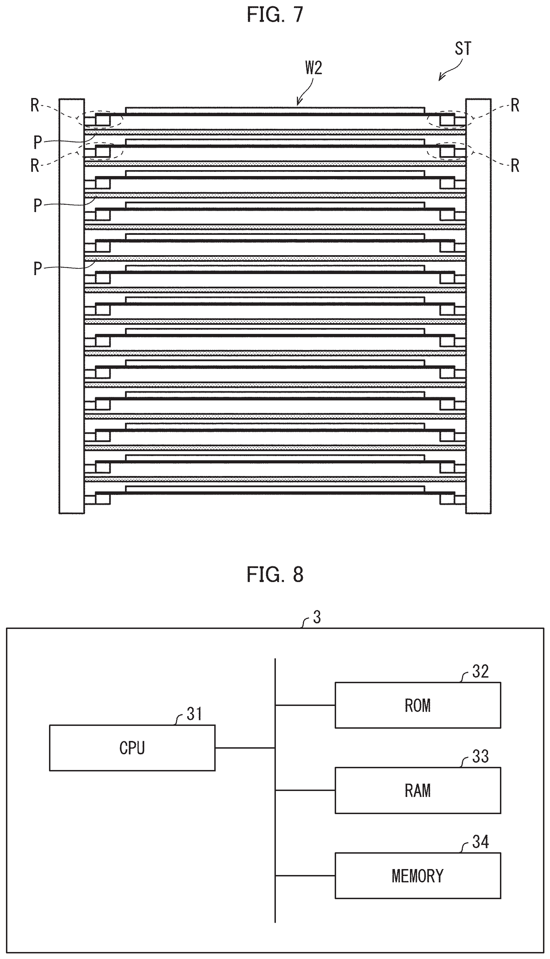

Fig. 6 is a perspective view illustrating a configuration of a framed substrate accommodating section ST. Fig. 7 is a side view illustrating the configuration of the framed substrate accommodating section ST. As illustrated in Figs. 6 and 7, the framed substrate accommodating section ST includes a shelf section R provided therein. In the shelf section R, a plurality of framed substrates W2 are placed so as to be vertically arranged.

The framed substrate accommodating section ST has a plurality of partition plates P that partition the plurality of framed substrates W2. By the plurality of partition plates P, the plurality of post-processing framed substrates W2 placed side by side in the up-down direction in the shelf section R are partitioned.

The framed substrate accommodating section ST is disposed laterally to the delivery unit PASS. This enables smooth transfer of the framed substrate W2 between the framed substrate accommodating section ST and the delivery unit PASS.

### Configuration of Control Section

Next, the following will describe a configuration of the control section 3 with reference to Fig. 8. Fig. 8 is a block diagram illustrating an example of the configuration of the control section 3. As illustrated in Fig. 8, the control section 3 includes a Central Processing Unit (CPU) 31, a Read Only Memory (ROM) 32, a Random Access Memory (RAM) 33, and a memory 34. The CPU 31, ROM 32, RAM 33, and the memory 34 are electrically connected to each other via a bus.

The CPU 31 controls operation of the indexer section 1 and the processing section 2 by executing a program stored in the ROM 32. The RAM 33 functions as a temporary storage section for various data during control by the CPU 31. Various kinds of data are stored in the memory 34.

### Processing for Framed Substrate by Substrate Processing Apparatus

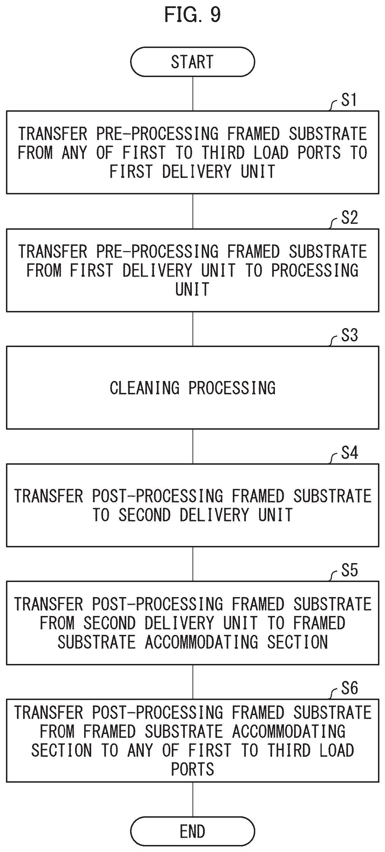

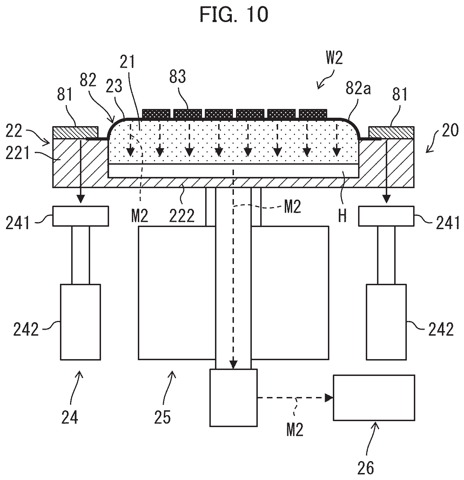

Next, the following will describe, with reference to Figs. 9 and 10, a flow of processing carried out by the substrate processing apparatus 100 with respect to a framed substrate W2. Fig. 9 is a flowchart illustrating the flow of processing on the framed substrate W2 carried out by the substrate processing apparatus 100. Fig. 10 is a diagram illustrating a state observed while cleaning processing is being carried out with respect to the framed substrate W2.

In the flowchart shown in Fig. 9, the control section 3 of the substrate processing apparatus 100 causes the indexer robot IR to transfer a pre-processing framed substrate W2 from any of the first load port LP1 to the third load port LP3 to the first delivery unit PASS1 (Step S1).

After Step S1, the control section 3 causes the center robot CR to transfer the pre-processing framed substrate W2 from the first delivery unit PASS1 to the processing unit U (Step S2).

The control section 3 may cause the indexer robot IR to transfer the pre-processing framed substrate W2 from any of the first load port LP1 to the third load port LP3 to the second delivery unit PASS2, and may cause the center robot CR to transfer the pre-processing framed substrate W2 from the second delivery unit PASS2 to the processing unit U.

After Step S2, the control section 3 carries out cleaning processing with respect to the pre-processing framed substrate W2 in the processing unit U (Step S3).

In Step S3, the control section 3 controls the holding drive section 24 to adjust a magnetic attraction force acting between the frame 81 and the magnet 241, as illustrated by an arrow M1 in Fig. 10. The control section 3 controls the suction section 26 so that a gas is sucked from the adsorption surface 23 through the porous member 21 and the gap H, as illustrated by an arrow M2 in Fig. 10. Consequently, the film 82 is adsorbed and held by the adsorption surface 23 of the porous member 21.

Then, the control section 3 controls the rotation drive section 25 so that the framed substrate W2 held by the substrate retaining section 20 rotates around the rotation axis Q. The processing unit U cleans the framed substrate W2 by discharging the processing liquid through the nozzle 61 toward the rotating framed substrate W2. Thereafter, the control section 3 dries the framed substrate W2 by, for example, rotating the framed substrate W2.

After Step S3, the control section 3 causes the center robot CR to transfer the post-processing framed substrate W2 from the processing unit U to the second delivery unit PASS2 (Step S4). Note that the control section 3 may cause the center robot CR to transfer the post-processing framed substrate W2 to the first delivery unit PASS1.

After Step S4, the control section 3 causes the indexer robot IR to transfer the post-processing framed substrate W2 from the second delivery unit PASS2 to the framed substrate accommodating section ST (Step S5). The post-processing framed substrate W2 is accommodated in the framed substrate accommodating section ST for a predetermined period. In this manner, by accommodating the post-processing framed substrate W2 in the framed substrate accommodating section ST for a predetermined period, that is, for a period from a time when the post-processing framed substrate W2 is transferred to the framed substrate accommodating section ST to a time when the post-processing framed substrate W2 is transferred to any of the first load port LP1 to the third load port LP3, it is possible to prevent processing in the substrate processing apparatus 100 from being delayed.

After Step S5, the control section 3 causes the indexer robot IR to transfer the post-processing framed substrate W2 from the framed substrate accommodating section ST to any of the first load port LP1 to the third load port LP3 (Step S6). As described above, the control section 3 ends the processing with respect to the framed substrate W2.

A position where the post-processing framed substrate W2 is unloaded from the framed substrate accommodating section ST by the indexer robot IR in Step S5 and a position where the post-processing framed substrate W2 is loaded into any of the first load port LP1 to the third load port LP3 by the indexer robot IR in Step S6 are set at a same height. This enables smooth transfer of the post-processing framed substrate W2.

Further, it is preferable that a carrier in which the pre-processing framed substrate W2 is accommodated is different from a carrier to which a post-processing framed substrate W2 is transferred in Step S6. Consequently, the post-processing framed substrate W2 can be accommodated in a clean carrier, which also makes it possible to reduce or prevent a reduction of throughput in the substrate processing apparatus 100.

### Processing for General Substrate by Substrate Processing Apparatus

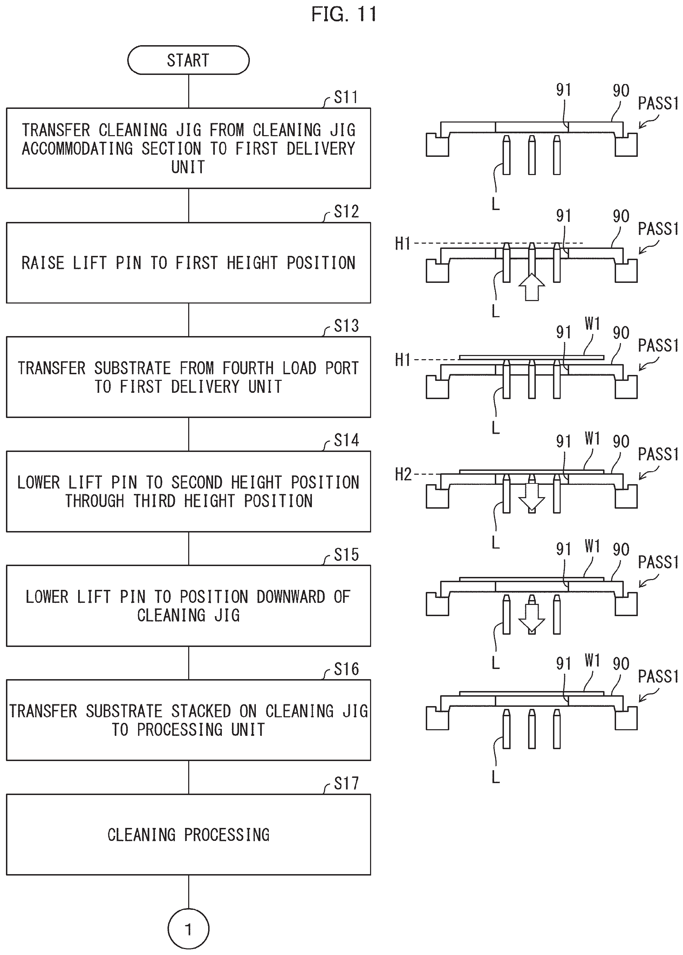

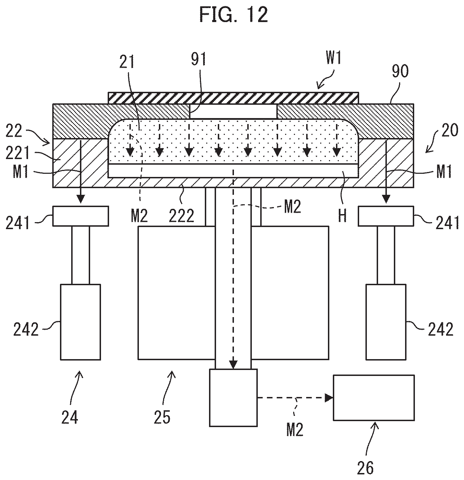

Next, the following will describe, with reference to Figs. 11 to 13, a flow of cleaning processing carried out by the substrate processing apparatus 100 with respect to a general substrate W1. Fig. 11 is a flowchart illustrating a flow of processing carried out up to cleaning of the general substrate W1, the processing being carried out by the substrate processing apparatus 100. Fig. 12 is a diagram illustrating a state observed while cleaning processing is being carried out by the substrate processing apparatus 100 with respect to a substrate with a cleaning jig.

In the flowchart shown in Fig. 11, the control section 3 causes the center robot CR to transfer the cleaning jig 90 from the cleaning jig accommodating section 9 to the first delivery unit PASS1, as illustrated by an arrow A11 in Fig. 4 (Step S11). The center robot CR transfers the cleaning jig 90 accommodated in the cleaning jig accommodating section 9 to a position above the lift pins L located at a lowest standby position.

After Step S11, the control section 3 drives a motor (not illustrated) to raise the lift pins L to a first height position H1 through the opening 91 of the cleaning jig 90 (Step S12).

After Step S12, the control section 3 causes the indexer robot IR to transfer the substrate W1 from the fourth load port LP4 to the first delivery unit PASS1, as illustrated by an arrow A13 in Fig. 4 (Step S13).

In Step S13, the indexer robot IR transfers the substrate W1 accommodated in the fourth load port LP4 to a location above the lift pins L and above the cleaning jig 90, and thereafter brings the substrate W1 into contact with upper parts of the lift pins L. The plurality of lift pins L receive the substrate W1 at the first height position H1.

After Step S13, the control section 3 drives the motor to lower the lift pins L to the second height position H2 through a third height position H3 (Step S14). In this manner, the lift pins L are raised and lowered in a range including the first height position H1 and the second height position H2, so that the substrate W1 is stacked on the cleaning jig 90.

In Step S14, in lowering the lift pins L from the first height position H1 to the second height position H2, the control section 3 controls the motor to decrease a lowering speed of the lift pins L stepwise. This makes it possible to reduce or prevent deviation of the placement position of the substrate W1 when stacking the substrate W1 on the cleaning jig 90.

Specifically, the control section 3 controls the lowering speed of the lift pins so as to be decreased stepwise in a process in which the lift pins L are lowered from the third height position H3 to the second height position H2. The third height position H3 is a height position located between the first height position H1 and the second height position H2. Note that a height between the first height position H1 and the second height position H2 is preferably set according to a thickness of the frame 81 and an amount of deflection of the substrate W1.

After Step S14, the control section 3 drives the motor to lower the lift pins L to a position below the cleaning jig 90 (Step S15), and obtains the substrate with the cleaning jig, which is the substrate W1 stacked on the cleaning jig 90, as a pre-processing substrate.

After Step S15, the control section 3 causes the pre-processing substrate, which is the substrate W stacked on the cleaning jig 90, to be transferred from the first delivery unit PASS1 to the processing unit U by the center robot CR as illustrated by an arrow A16 in Fig. 4 (Step S16).

After Step S16, in the processing unit U, the control section 3 carries out cleaning processing with respect to the substrate W1 stacked on the cleaning jig 90 (Step S17).

In Step S17, the control section 3 controls the holding drive section 24 to adjust a magnetic attraction force acting between the cleaning jig 90 and the magnet 241, as illustrated by an arrow M1 in Fig. 12. Further, the control section 3 controls the suction section 26 to suck a gas through the porous member 21 and the gap H, as illustrated by an arrow M2 in Fig. 12. Consequently, the cleaning jig 90 and the substrate W1 are adsorbed and held by the porous member 21.

Subsequently, the control section 3 controls the rotation drive section 25 to rotate the substrate W1 held by the substrate retaining section 20 around the rotation axis Q. Similarly to Fig. 3, the substrate retaining section 20 includes the porous member 21, the base 22, the holding drive section 24, and the rotation drive section 25.

Then, the processing unit U cleans the substrate W1 by discharging the processing liquid through the nozzle 61 toward the rotating substrate W1. Thereafter, the control section 3 dries the substrate W1 by, for example, rotating the substrate W1.

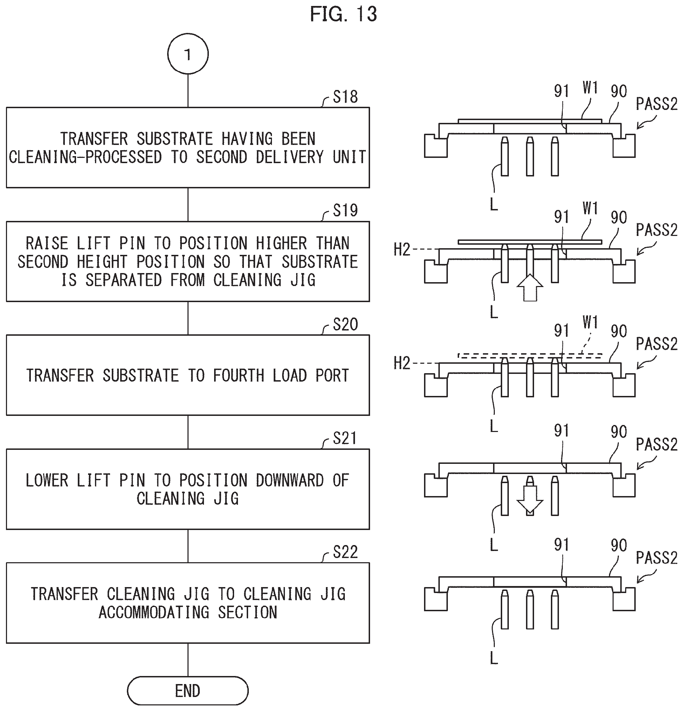

Next, the following will describe, with reference to Fig. 13, a flow of processing carried out by the substrate processing apparatus 100 with respect to a general substrate W1 having been subjected to cleaning processing. Fig. 13 is a flowchart illustrating the flow of processing carried out by the substrate processing apparatus 100 with respect to the general substrate W1 having been subjected to cleaning processing.

In the flowchart shown in Fig. 13, as illustrated by an arrow A18 in Fig. 4, the control section 3 causes the center robot CR to transfer the substrate W1 with the cleaning jig having been cleaned in the processing unit U from the processing unit U to the second delivery unit PASS2 as a post-processing substrate (Step S18).

After Step S18, the control section 3 drives the motor to raise the lift pins L to the first height position H1, which is higher than the second height position H2, through the opening 91 of the cleaning jig 90 while bringing the lift pins L into contact with the substrate W1, so that the substrate W1 is separated from the cleaning jig 90 (Step S19).

In Step S19, in the process in which the lift pins L are raised to the first height position H1 for the post-processing substrate having been subjected to cleaning by the processing unit U, the control section 3 controls a rising speed of the lift pins L to be decreased stepwise. This makes it possible to place the substrate W1 on the lift pins L without deviation.

After Step S19, the control section 3 causes the indexer robot IR to transfer the substrate W1 from the second delivery unit PASS2 to the fourth load port LP4, as illustrated by an arrow A20 in Fig. 4 (Step S20).

After Step S20, the control section 3 drives the motor to lower the lift pins L to a position below the cleaning jig 90 (Step S21). By raising and lowering the lift pins L in this manner, it is possible to quickly separate the cleaning jig 90 from the substrate W1 in the second delivery unit PASS2.

After Step S21, the control section 3 causes the center robot CR to transfer the cleaning jig 90 from the second delivery unit PASS2 to the cleaning jig accommodating section 9, as illustrated by an arrow A22 in Fig. 4 (Step S22). In the manner described above, the control section 3 ends the processing with respect to the general substrate W1.

### Effects of Embodiment

The substrate processing apparatus 100 according to the foregoing present embodiment carries out cleaning of a general substrate W1 in the following manner. That is, the control section 3 causes the center robot CR to transfer the cleaning jig 90 from the cleaning jig accommodating section 9 to the first delivery unit PASS1 (Step S11), then causes the indexer robot IR to transfer the substrate W1 from the fourth load port LP4 to the first delivery unit PASS1 (Step S13), and stacks the substrate W1 on the cleaning jig 90 in the first delivery unit PASS1 so that the substrate W1 with the cleaning jig is provided as a pre-processing substrate. Thereafter, the control section 3 causes the center robot CR to transfer the pre-processing substrate from the first delivery unit PASS1 to the processing unit U, and carries out cleaning processing with respect to the pre-processing substrate in the processing unit U (Step S17).

Meanwhile, cleaning of the framed substrate W2 is carried out in the following manner, without using the cleaning jig 90. That is, the control section 3 causes the center robot CR to transfer a pre-processing framed substrate W2 from the first delivery unit PASS1 to the processing unit U (Step S2), and then carries out cleaning processing with respect to the pre-processing framed substrate W2 in the processing unit U (Step S3).

In this manner, in a case where cleaning of the general substrate W1 is carried out, the substrate W1 is stacked on the cleaning jig 90 and the substrate with the cleaning jig is transferred to the processing unit U as a pre-processing substrate. By doing so, cleaning of the general substrate W1 can be carried out in a transfer mode similar to that for cleaning of the framed substrate W2. Consequently, the general substrate W1 can be cleaned by using equipment similar to that for the framed substrate W2. Thus, it is possible to reduce a size and a cost of the substrate processing apparatus 100.

In particular, in Steps S13 to S15, in a process in which the lift pins L are lowered from the first height position H1 to the second height position H2, the control section 3 controls the motor to decrease a lowering speed of the lift pins L stepwise. Specifically, the control section 3 controls a lowering speed of the lift pins L so as to be decreased in lowering the lift pins L from the third height position H3 to the second height position H2. This makes it possible to reduce or prevent positional deviation that may occur when the cleaning jig 90, which is required when cleaning of the general substrate W1 is carried out by equipment similar to that for the framed substrate W2, is stacked on the substrate W1.

Moreover, the control section 3 causes the indexer robot IR to transfer the post-processing framed substrate W2 from the second delivery unit PASS2 to the framed substrate accommodating section ST (Step S5). Then, after accommodating the post-processing framed substrate W2 in the framed substrate accommodating section ST for a predetermined period, the control section 3 causes the indexer robot IR to transfer the post-processing framed substrate W2 from the framed substrate accommodating section ST to any one of the first load port LP1 to the third load port LP3 (Step S6). Consequently, a process of transferring the framed substrate W2 to the framed substrate accommodating section ST after cleaning the framed substrate W2 can be efficiently carried out while cleanliness of the cleaned framed substrate W2 is secured.

Furthermore, after transferring the cleaning jig 90 from the cleaning jig accommodating section 9 to the first delivery unit PASS1 (Step S11), the control section 3 raises the lift pins L to the first height position (Step S12). Thereafter, the control section 3 causes the substrate W1 to be transferred from the fourth load port LP4 to the first delivery unit PASS1 (Step S13), places the substrate W1 on the lift pins L, and lowers the lift pins L to the second height position H2 (Step S14). Consequently, the substrate with the cleaning jig is obtained. In this manner, by operating the lift pins L, it is possible to efficiently prepare the substrate with the cleaning jig in the first delivery unit PASS1.

Moreover, the control section 3 causes the indexer robot IR to transfer the substrate W1 from the second delivery unit PASS2 to the fourth load port LP4 (Step S20), and causes the center robot CR to transfer the cleaning jig 90 from the second delivery unit PASS2 to the cleaning jig accommodating section 9 (Step S22). In this manner, different transfer mechanisms are used in order that the substrate with the cleaning jig having been cleaned in the processing unit U is separated into the cleaning jig 90 and the substrate W1. By doing so, it is possible to quickly carry out separation of the substrate with the cleaning jig.

Furthermore, in the substrate processing apparatus 100, stacking of the cleaning jig 90 and the substrate W1 is carried out in the first delivery unit PASS1, whereas separation of the cleaning jig 90 and the substrate W1 is carried out in the second delivery unit PASS2. In this manner, the stacking and the separation of the cleaning jig 90 and the substrate W1 are carried out at different locations. By doing so, it is possible to increase a speed of processing by the substrate processing apparatus 100.

Moreover, the framed substrate accommodating section ST is separated in the up-down direction by the plurality of partition plates P. This prevents processing liquid or the like remaining on the post-processing framed substrate W2 placed in the upper accommodating space from entering the lower accommodating space and contaminating the post-processing framed substrate W2 placed in the lower accommodating space.

### Other Embodiments

In the above-described embodiment, two processing units U are provided in the substrate processing apparatus 100. However, the present invention is not limited to this. Alternatively, for example, four processing units U may be provided. Further, the processing units U may be arranged in two layers in the up-down direction.

Moreover, a camera unit that obtains an image of the post-processing framed substrate W2 or substrate W1 having been transferred to the second delivery unit PASS2 may be provided in the vicinity of the second delivery unit PASS2. By obtaining an image of the framed substrate W2 or substrate W1 after Step S4 or after Step S18 with the camera unit, it is possible to check whether or not a chip is normally arranged on the post-processing framed substrate W2 or substrate W1 and whether or not the cleaning processing has been carried out appropriately.

Aspects of the present invention can also be expressed as follows:
A substrate processing apparatus according to an aspect of the present disclosure is a substrate processing apparatus including: a substrate accommodating section; a cleaning jig accommodating section; a transfer mechanism; a substrate placement section provided with a lift pin that is raised and lowered by motor driving; a processing unit; and a control section. The transfer mechanism transfers a cleaning jig accommodated in the cleaning jig accommodating section to a position above the lift pin located at a lowest standby position, and transfers a substrate accommodated in the substrate accommodating section to a position above the lift pin and above the cleaning jig. The lift pin is raised and lowered at least in a range including (a) a first height position where the substrate having been transferred from the substrate accommodating section by the transfer mechanism is received and (b) a second height position where the substrate is stacked on the cleaning jig. The control section controls a lowering speed of the lift pin to be decreased stepwise in a process in which the lift pin is lowered from the first height position to the second height position. The substrate stacked on the cleaning jig at the second height position is transferred, by the transfer mechanism, as a pre-processing substrate to the processing unit that carries out cleaning processing.

In a substrate processing apparatus according to an aspect of the present disclosure, the transfer mechanism includes a first transfer mechanism and a second transfer mechanism. The first transfer mechanism transfers a substrate accommodated in the substrate accommodating section to the substrate placement section. The second transfer mechanism transfers the cleaning jig accommodated in the cleaning jig accommodating section to the substrate placement section, and transfers the pre-processing substrate from the substrate placement section to the processing unit.

In a substrate processing apparatus according to an aspect of the present disclosure, a height position located between the first height position and the second height position is defined as a third height position; and the control section controls a lowering speed of the lift pin to be decreased stepwise in a process in which the lift pin is lowered from the third height position to the second height position.

In a substrate processing apparatus according to an aspect of the present disclosure, the control section controls a rising speed of the lift pin to be decreased stepwise in a process in which the lift pin is raised to the second height position for a post-processing substrate, which is the pre-processing substrate having been cleaned by the processing unit. The lift pin is raised to a position higher than the second height position, so that the post-processing substrate is separated into the substrate and the cleaning jig.

In a substrate processing apparatus according to an aspect of the present disclosure, the cleaning jig has an opening; and the lift pin is raised and lowered through the opening.

The present invention is not limited to the above-described embodiments, and various modifications are possible within the scope shown in the claims, and embodiments obtained by appropriately combining technical means disclosed in different embodiments are also included in the technical scope of the present invention.

### Reference Signs List

1: Indexer section
2: Processing section
3: Control section
90: Cleaning jig
91: Opening
100: Substrate processing apparatus
H1: First height position
H2: Second height position
H3: Third height position
L: Lift pin
U: Processing unit
W1: Substrate
W2: Framed substrate
IR: Indexer robot (transfer mechanism, first transfer mechanism)
CR: Center robot (transfer mechanism, second transfer mechanism)
LP1: First load port
LP2: Second load port
LP3: Third load port
LP4: Fourth load port (substrate accommodating section)
PASS: Delivery unit (substrate placement section)
PASS1: First delivery unit (substrate placement section)
PASS2: Second delivery unit (substrate placement section)

## Claims

1. A substrate processing apparatus comprising:
a substrate accommodating section;
a cleaning jig accommodating section;
a transfer mechanism;
a substrate placement section provided with a lift pin that is raised and lowered by motor driving;
a processing unit; and
a control section,
the transfer mechanism transferring a cleaning jig accommodated in the cleaning jig accommodating section to a position above the lift pin located at a lowest standby position, and transferring a substrate accommodated in the substrate accommodating section to a position above the lift pin and above the cleaning jig,
the lift pin being raised and lowered at least in a range including (a) a first height position where the substrate having been transferred from the substrate accommodating section by the transfer mechanism is received and (b) a second height position where the substrate is stacked on the cleaning jig,
the control section controlling a lowering speed of the lift pin to be decreased stepwise in a process in which the lift pin is lowered from the first height position to the second height position, and
the substrate stacked on the cleaning jig at the second height position being transferred, by the transfer mechanism, as a pre-processing substrate to the processing unit that carries out cleaning processing.

2. The substrate processing apparatus according to claim 1, wherein:
the transfer mechanism includes a first transfer mechanism and a second transfer mechanism;
the first transfer mechanism transfers the substrate accommodated in the substrate accommodating section to the substrate placement section; and
the second transfer mechanism transfers the cleaning jig accommodated in the cleaning jig accommodating section to the substrate placement section, and transfers the pre-processing substrate from the substrate placement section to the processing unit.

3. The substrate processing apparatus according to claim 1 or 2, wherein:
a height position located between the first height position and the second height position is defined as a third height position; and
the control section controls a lowering speed of the lift pin to be decreased stepwise in a process in which the lift pin is lowered from the third height position to the second height position.

4. The substrate processing apparatus according to any one of claims 1 to 3, wherein:
the control section controls a rising speed of the lift pin so as to be decreased stepwise in a process in which the lift pin is raised to the second height position for a post-processing substrate, which is the pre-processing substrate having been cleaned by the processing unit; and
the lift pin is raised to a position higher than the second height position, so that the post-processing substrate is separated into the substrate and the cleaning jig.

5. The substrate processing apparatus according to any one of claims 1 to 4, wherein:
the cleaning jig has an opening; and
the lift pin is raised and lowered through the opening.
